Europäisches Patentamt

European Patent Office

Office européen des brevets

(11) Numéro de publication: **0 395 492**
**A1**

## (12) DEMANDE DE BREVET EUROPEEN

(21) Numéro de dépôt: **90401101.2**

(22) Date de dépôt: **24.04.90**

(51) Int. Cl.5: **H01L 31/075, H01L 31/052**

(30) Priorité: **27.04.89 FR 8905602**

(43) Date de publication de la demande:
**31.10.90 Bulletin 90/44**

(84) Etats contractants désignés:
**BE CH DE ES GB IT LI LU**

(71) Demandeur: **SOLEMS S.A. Société dite:**
**3, rue Léon Blum Z.I. Les Glaises**
**F-91120 Palaiseau(FR)**

(72) Inventeur: **Schmitt, Jacques**
**51, Grande Rue**
**F-91620 La Ville du Bois(FR)**

(74) Mandataire: **Lerner, François et al**
**LERNER & BRULLE S.C.P. 5, rue Jules**
**Lefèbvre**
**F-75009 Paris(FR)**

(54) **Procédé pour améliorer la réponse spectrale d'une structure photoconductrice, cellule solaire et structure photoréceptive améliorées.**

(57) L'invention vise à améliorer la réponse spectrale d'une structure photoconductrice prévue pour recevoir un rayonnement lumineux et comprenant un substrat (3), une couche transparente électriquement conductrice (5), une couche semi-conductrice de conversion photoélectrique (7) dans laquelle est incorporée au moins une sous-couche semi-conductrice complémentaire (13a, 13b, 130) ayant un seuil d'absorption optique et une longueur de diffusion des charges électriques inférieurs à celui, respectivement celle, du matériau constituant la couche de conversion photoélectrique,
et une électrode arrière (9) à surface réfléchissante (9a).

Selon l'invention, les sous-couches complémentaires (13a, 13b, 13c...) sont incorporées dans le voisinage immédiat de certaines des zones où le carré du champ électrique optique des ondes stationnaires issues de la combinaison des rayonnements lumineux incidents et réfléchis est maximal.

L'invention s'applique en particulier pour la fabrication des cellules solaires et autres structures photo-réceptives.

FIG.1

L'invention concerne tout d'abord un procédé pour améliorer, dans une bande déterminée de longueurs d'onde, la réponse spectrale d'une structure photoconductrice exposée à un rayonnement lumineux.

En outre, l'invention a pour objet une structure multicouche photo-réceptive améliorée, ainsi qu'une cellule solaire en films minces "simple" ou du type connu sous l'appellation "tandem" ou "multijonction".

On sait aujourd'hui parfaitement que les structures photoconductrices, telles que les cellules solaires, qui sont prévues pour recevoir des rayonnements lumineux, sont réalisées autour d'au moins une couche de conversion photoélectrique constituée par un matériau semi-conducteur qui absorbe les photons de lumière incidente lorsque l'énergie électrique de ces photons est supérieure au seuil d'absorption optique du semi-conducteur considéré.

Pour mémoire, on rappellera dès à présent que le seuil d'absorption optique, également appelé "gap optique" pour un semi-conducteur correspond à un seuil en énergie des photons. Pour une lumière monochromatique dont l'énergie photonique est inférieure à ce seuil le matériau est transparent, par contre, pour une énergie supérieure au seuil le matériau est absorbant. En pratique et dans la mesure où la transition n'est pas strictement brutale et où le concept de transparence dépend de l'épaisseur du matériau, nous définirons ce seuil à une absorption optique de l'ordre de 60 % pour une couche de semi-conducteur dont l'épaisseur est typique de celles utilisées dans les structures photoélectriques en couches minces, soit 1 micron environ.

Le seuil d'absorption peut être défini par la longueur d'onde (dans le vide) de la lumière de même énergie. Energies et longueurs d'onde étant inversement proportionnelles, les longueurs d'onde plus courtes (plus bleues) que le seuil seront absorbées alors que les longueurs d'onde plus grandes (plus rouges) traverseront en majorité la structure sans absorption donc sans déclencher les processus photoélectriques qui activent cette structure.

On notera également que dans ce qui suit, on appellera "bande spectrale" d'une structure photoélectrique, la zone de longueurs d'onde pour laquelle la structure convertit effectivement la lumière qu'elle reçoit en courant électrique.

Quant à l'expression "longueur de diffusion des charges", elle définira la distance moyenne parcourue par les charges (porteurs libres) au sein du semi-conducteur considéré, avant que ces charges disparaissent par recombinaison (entre les électrons et les trous).

L'exemple typique qui va suivre va permettre de mettre en lumière ces différentes notions. Le cas choisi concerne une cellule solaire au silicium amorphe (aSi:H) de type p-i-n ; (c'est-à-dire dont la couche de conversion photoélectrique comprend une sous-couche semi-conductrice intrinsèque (de type i) interposée entre une sous-couche de type p et une sous-couche de type n.

Avec ce type de cellule, le seuil d'absorption optique est limité vers la lumière rouge par le seuil d'absorption optique du silicium amorphe.

Si dans la couche de silicium amorphe, les longueurs d'onde correspondant à une lumière bleue sont absorbées après quelques dizaines de nanomètre (1 nm = $10^{-9}$ m), les longueurs d'onde correspondant à une lumière verte ne le sont qu'après un parcours de quelques centaines de nanomètre. Par contre, une lumière d'un rouge "profond" (longueur d'onde de l'ordre de 700 nm) n'est absorbée qu'après avoir parcouru quelques microns dans le matériau.

Afin d'élargir la bande spectrale et de repousser vers le rouge la limite de fonctionnement des structures photoélectriques à semi-conducteur (cellules solaires, photo-récepteurs...), on a déjà proposé d'augmenter jusqu'au seuil techniquement admissible (quelques microns) l'épaisseur de ces structures.

Mais on s'est rapidement aperçu que survenaient alors des problèmes dûs à l'imperfection relative des semi-conducteurs utilisés (en particulier aSi:H), en termes de transport des charges électriques électrons-trous : Si la couche de conversion photoélectrique est épaisse, les paires électrons-trous sont entraînées par un champ électrique relativement faible, ceci sur une relativement longue distance, et ces paires demeurent relativement longtemps dans le semi-conducteur où elles ont une durée de vie qui est de l'ordre de la durée des processus de recombinaison des charges au sein du matériau. Dans ce cas, les charges électriques sont donc perdues avant d'avoir été collectées.

En ce qui concerne plus particulièrement les gammes de longueurs d'onde correspondant à la lumière rouge, on considère actuellement qu'une sous-couche de type i (intrinsèque) de 0,3 à 0,5 micron d'épaisseur est suffisamment épaisse pour collecter une partie importante des photons de lumière rouge dans le spectre visible, tout en restant suffisamment fine pour que l'efficacité de la collecte et le facteur de forme demeurent acceptables.

On notera que de façon à obtenir un rendement photovoltaïque en lumière solaire supérieur à 10 %, différentes améliorations techniques ont été proposées qui tendent à contourner le problème de l'absorption optique.

Il a notamment été prévu de réaliser les structures avec un contact ou électrode arrière, à surface réfléchissante qui ait un pouvoir très élevé de réflexion afin de doubler au moins le trajet optique (par exemple en lumière rouge). Il a également été prévu de rendre rugueuses les surfaces de contact des couches entre-elles de façon à obtenir une diffusion de la lumière et à réaliser son piégeage optique au sein de la structure, dans la gamme de longueurs d'onde considérée.

On notera que dans le cas des cellules solaires, augmenter la réponse spectrale en lumière rouge est d'une importance majeure pour le rendement photovoltaïque, puisque la lumière solaire à laquelle sont exposées ces cellules contient une très large proportion de photons "rouges".

En particulier pour étendre la bande spectrale vers le rouge, une solution a notamment été proposée consistant à intégrer ou à incorporer au semi-conducteur utilisé (par exemple à base de silicium amorphe), un semi-conducteur complémentaire tel qu'un alliage silicium-germanium ayant un seuil d'absorption et une longueur de diffusion de charges inférieurs à ceux du premier semi-conducteur cité.

Si cette solution est séduisante dans son principe (la bande spectrale est effectivement étendue vers le rouge), le bilan s'est toutefois avéré globalement négatif, l'adjonction du semi-conducteur complémentaire entraînant une diminution du courant photoélectrique global pouvant être fourni par la structure.

L'invention a pour objet de rendre profitable l'introduction du semi-conducteur complémentaire. L'idée maîtresse de cette invention consiste à n'incorporer le semi-conducteur complémentaire à plus faible seuil d'absorption optique qu'aux endroits où la densité des photons à absorber dans la gamme de longueurs d'onde considérée, est la plus forte.

Plus précisément, le procédé de l'invention vise à améliorer, dans une bande déterminée de longueurs d'onde, la réponse spectrale d'une structure photoconductrice exposée à un rayonnement lumineux et comprenant en succession :
- une couche transparente électriquement conductrice,
- une couche de conversion photoélectrique constituée à partir d'un matériau semi-conducteur,
- et une électrode arrière à surface réfléchissante permettant de réfléchir vers les couches précédentes un rayonnement incident après que celui ait traversé lesdites couches, pour obtenir des ondes combinées stationnaires,
ce procédé consistant à incorporer dans, ou à la surface de, la couche de conversion photoélectrique, au moins une sous-couche complémentaire de plus faible épaisseur constituée à partir d'un autre matériau semi-conducteur ayant un seuil

d'absorption optique et une longueur de diffusion des charges électriques, inférieurs à celui, respectivement celle, du matériau constituant la couche de conversion photoélectrique, le procédé de l'invention se caractérisant en ce qu'on incorpore la (les) sous-couche(s) complémentaire(s) dans le voisinage immédiat de l'une, ou de certaines, des zones où le carré du champ électrique optique des ondes stationnaires issues de la combinaison des rayonnements lumineux incident et réfléchi est maximal.

Selon l'invention, on disposera la sous-couche complémentaire qui est la plus proche de la surface réfléchissante de telle sorte que le trajet optique moyen entre cette surface réfléchissante et le milieu de ladite sous-couche complémentaire soit égal à environ $\lambda o(\frac{1}{4} + \frac{k}{2})$, le trajet optique séparant entre-elles les sous-couches complémentaires étant égal, dans le cas où l'on incorpore plusieurs de ces sous-couches, à environ $\dfrac{\lambda o}{2}$ ;

$k$ étant un entier relatif positif ou nul, généralement compris entre 0 et 3, et $\lambda o$ étant la longeur d'onde moyenne du rayonnement lumineux dans le vide et dans la bande de longueurs d'onde considérée (type de lumière devant être absorbé), ladite bande étant située entre les seuils d'absorption optique des matériaux semi-conducteurs constituant la couche de conversion photoélectrique de la structure et les sous-couches complémentaires, respectivement.

Comme précédemment mentionné, l'invention se rapporte également à une structure multicouche photo-réceptive ainsi qu'à une cellule solaire de type p-i-n ou n-i-p ou encore du type tandem.

Dans le cadre de l'invention, on notera que la structure multicouche photo-réceptive sus-mentionnée comprend un empilage de couches minces constituées par :
- une couche transparente électriquement conductrice formant une barrière de SCHOTTKY,
- une couche de conversion photoélectrique formée sur ladite couche transparente et constituée à partir d'un matériau semi-conducteur, ladite couche de conversion photoélectrique comprenant une première sous-couche de type i et une seconde sous-couche de type n,
- au moins une sous-couche complémentaire telle que précédemment définie et formée dans, ou sur, la sous-couche i,
- une électrode arrière à surface réfléchissante, formée sur la couche de conversion photoélectrique,
- et un substrat formé soit sur une face de la couche transparente opposée à celle où est formée la couche de conversion photoélectrique (dans ce cas le substrat sera transparent), soit sur une face de l'électrode arrière opposée à celle où ladite électrode est formée sur la couche de conversion photoélectrique, cette structure se caractérisant par le fait que la (les) sous-couche(s) complémentaire(s) est (sont) disposée(s) dans, ou à la surface de, la sous-couche de type i dans le voisinage immédiat de l'une, ou de certaines, des zones où le carré du champ électrique optique des ondes stationnaires issues de la combinaison des rayonnements lumineux incident et réfléchi est maximal.

Grâce à l'invention, de nombreux avantages vont pouvoir être obtenus et notamment :

a. les propriétés électroniques de la structure vont pouvoir être maintenues à un niveau tout à fait acceptable, le semi-conducteur complémentaire à plus faible seuil d'absorption optique n'étant intégré à cette structure qu'aux endroits appropriés où il produit sa meilleure efficacité en minimisant son effet négatif sur le transport des charges électriques au sein des couches ;

b. les photons de la bande lumineuse qui doivent être absorbés par la sous-couche de matériau complémentaire sont contenus dans une bande de longueurs d'onde relativement étroite comprise entre les seuils d'absorption optique des deux semi-conducteurs utilisés respectivement pour constituer la couche de conversion photoélectrique et la sous-couche complémentaire. Dans le cas du aSi:H et du aSi-Ge:H, cela correspond environ à une largeur de bande de l'ordre de 650 à 760 nm ;

c. Avec une surface réfléchissante arrière à pouvoir de réflexion élevé et grâce au faible niveau d'absorption optique du semi-conducteur "principal", une onde lumineuse donnée (par exemple en lumière rouge) va pouvoir fournir une onde stationnaire dont on pourra précisément définir la position et la forme ;

d. du fait de la combinaison ou de l'interférence des ondes stationnaires incidentes et réfléchies, l'intensité lumineuse (correspondant au carré du champ optique local) est nulle à proximité immédiate de la surface réfléchissante et présente au sein des différentes couches constitutives de la structure, une série de minima et de maxima répartis suivant une période spatiale sensiblement régulière (que l'on peut typiquement situer entre 85 et 95 nm environ dans une couche de aSi:H, pour une longueur d'onde moyenne de l'ordre de 720 à 730 nm) ;

e. du fait du fort indice optique des matériaux semi-conducteurs utilisés (tels que le silicium et l'alliage silicium-germanium) l'onde lumineuse est toujours sensiblement normale au semi-conducteur, ceci même si la lumière pénètre dans la structure sous un angle d'incidence élevé. En conséquence, la période d'interférence des ondes incidentes et réfléchies dépend très peu de la valeur de l'angle d'incidence ;

f. compte tenu des caractéristiques mentionnées ci-dessus, le nombre des sous-couches complémentaires pourra être librement choisi en fonction de l'application retenue (type de structure, bande spectrale considérée, nature des semi-conducteurs...) ;

D'autres caractéristiques et avantages apparaîtront encore de la description qui va suivre faite en référence aux dessins annexés dans lesquels :

- la figure 1 illustre de façon schématique une cellule solaire conforme à l'invention, de type n-i-p,

- la figure 2 montre l'évolution du carré du champ électrique optique des ondes stationnaires issues de la combinaison des rayonnements lumineux incidents et réfléchis au sein de la structure, sur l'épaisseur de la structure de la figure 1,

- la figure 3 montre en relation avec les figures 1 et 2, la correspondance existant entre la position des sous-couches complémentaires et le trajet optique au sein de la structure de la figure 1 (le rapport d'échelle entre les figures 2 et 3 correspondant à l'indice optique des couches concernées),

- la figure 4 illustre une variante de réalisation de la cellule solaire illustrée figure 1, la cellule illustrée sur cette figure 4 étant du type p-i-n à substrat arrière,

- la figure 5 présente le graphe d'évolution du carré du champ électrique optique des ondes stationnaires issues de la combinaison des rayonnements lumineux incidents et réfléchis circulant dans la cellule de la figure 4,

- la figure 6 illustre, en relation avec les figures 4 et 5, la correspondance existant entre l'évolution du champ électrique optique sur l'épaisseur de la structure et le trajet optique au sein de cette dernière (le rapport d'échelle des figures 4 et 5 correspond à l'indice optique des couches concernées),

- la figure 7 montre une autre variante de réalisation d'une cellule solaire conforme à l'invention, du type tandem n-i-p,

- la figure 8, présente, à l'image des figures 2 et 5, le graphe d'évolution du carré du champ électrique optique à travers la cellule de la figure 6,

- la figure 9 illustre une structure photoréceptrice multicouche conforme à l'invention,

- et la figure 10 montre, à l'image des figures 2, 5 et 8, l'évolution du carré du champ électrique optique dans la structure de la figure 9.

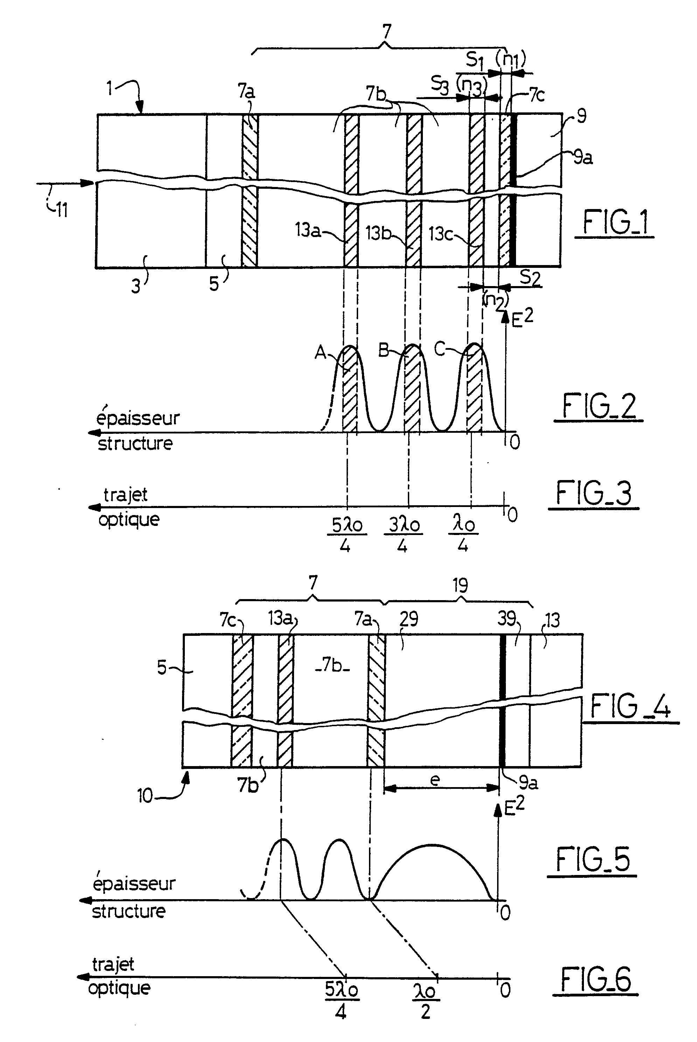

Intéressons nous tout d'abord aux figures 1 à 3.

La cellule solaire repérée dans son ensemble 1 et illustrée sur la figure 1 comprend successivement, une couche d'accrochage ou substrat 3, transparent, en verre ou en matériau équivalent, une couche transparente 5 électriquement conductrice constituée par exemple par un film d'oxyde d'étain ou d'oxyde de zinc formé sur le substrat 3, une couche ou feuillet de conversion photoélectrique 7 formée sur la couche transparente 5 par stratifications successives d'une première sous-couche dopée à conductivité électrique de type n, 7a, d'une deuxième sous-couche à conductivité de type i (couche intrinsèque à faible concentration d'impuretés),7b, et d'une troisième sous-couche dopée à conductivité de type p, 7c. Chacune de ces sous-couches est en l'espèce constituée à partir d'un semi-conducteur, notamment amorphe, tel a-Si:H -(silicium amorphe) ; mais on aurait également pu envisager par exemple de réaliser la couche de conversion photoélectrique avec un matériau semi-conducteur polycristallin. Une électrode, dite arrière, 9 formée sur la sous-couche de type p, 7c, complète la cellule. En l'espèce, l'électrode 9 est métallique (aluminium, argent ou équivalent) et présente au contact de la sous-couche de type p,7c, une surface réfléchissante 9a propre à réfléchir vers les couches précédentes de la cellule un rayonnement incident schématisé par la flèche 11 après que celui-ci ait traversé les différentes couches, de façon à obtenir au sein de la cellule des ondes combinées stationnaires, lesquelles ont été illustrées à la figure 2.

Sur la figure 1, on remarquera encore qu'au sein de la sous-couche de type i,7b, sont incorporées trois sous-couches complémentaires 13a, 13b, 13c à conductivité de type i (ou éventuellement très faiblement dopée) ayant chacune une épaisseur inférieure à celle de la sous-couche i 7b. Chaque sous-couche complémentaire 13, 13b, 13c est constituée à partir d'un matériau semi-conducteur ayant un seuil d'absorption optique (ou un "gap optique") et une longueur de diffusion des charges électriques (paires électrons-trous) créées par le passage des rayonnements lumineux à travers la cellule, inférieurs à celui, respectivement celle, du semi-conducteur constituant pour l'essentiel la couche de conversion photoélectrique 7. Dans le cas où la couche 7 sera réalisée à partir de silicium amorphe, les sous-couches complémentaires 13a..., seront alors de préférence constituées à partir d'un alliage silicium-germanium (Si-Ge).

Si l'on compare les figures 1 à 3, on remarque immédiatement que la disposition des sous-couches complémentaires 13, 13b, 13c n'est pas aléatoire ; mais qu'au contraire, les sous-couches complémentaires en question sont en l'espèce et conformément à l'invention incorporées dans la sous-couche i 7b dans le voisinage immédiate de certaine des zones où le carré du champ électrique optique $E^2$ des ondes stationnaires issues de la combinaison des rayonnements lumineux incident et réfléchi est maximal.

Dans le cas illustré, on remarquera que les trois sous-couches complémentaires en question ont été incoporées au niveau de chacune des trois premières zones, respectivement A, B, C les plus proches de la surface réfléchissante 9a où la valeur absolue du champ électrique optique des ondes stationnaires précitées est maximal ; c'est-à-dire que la première sous-couche complémentaire (en l'espèce 13c) qui est la plus proche de la surface réfléchissante 9a a été disposée de telle sorte que le trajet optique moyen entre la surface réfléchissante en question et sensiblement le milieu de cette même sous-couche soit égal à environ $\lambda o(\frac{1}{4} + \frac{k}{2})$, le trajet optique moyen séparant entre-elles les sous-couches complémentaires suivantes (13b, 13a) étant égal à environ $\dfrac{\lambda o}{2}$,

avec en l'espèce k (entier relatif) = 0, $\lambda o$ représentant bien entendu la longueur d'onde moyenne dans le vide du rayonnement lumineux reçu par la cellule

D'ailleurs, sur les figures 2 et 3, il apparaît clairement que les milieux des sous-couches 13c, 13b et 13a sont situés de telle sorte que les trajets optiques correspondants soient respectivement égaux à

$$\text{à } \frac{\lambda o}{4}, \ 3\frac{\lambda o}{4} \text{ et } 5\frac{\lambda o}{4}$$

(référence prise sur la surface réfléchissante 9a : origine de l'abscisse des courbes illustrées sur les figures 2 et 3).

Pour éviter toute ambiguité, on rappellera que le trajet optique moyen Tm peut se définir par :
Tm = $\int_c n_i \cdot dS$ ;
c'est-à-dire :
Tm = $n_1 s_1 + n_2 s_2 + n_3 s_3 + ...$
avec $n_i$ : indice optique local de réfraction, dans la couche ou sous-couche considérée ($n_1$, $n_2$...)
c : chemin suivi par le rayonnement lumineux le long du trajet optique,
s : distance parcourue par le rayonnement lumineux considéré au sein d'un matériau ayant un indice de réfraction défini (dans les cas illustrés dans la présente demande, cette distance correspond aux épaisseurs de chacune des couches et sous-couches constituant la structure photoconductrice puisque les couches sont disposées sensiblement perpendiculairement au rayonnement incident).

En pratique, la détermination des zones où sont susceptibles d'être déposées les sous-couches complémentaires sera relativement simple. En effet, il suffira tout d'abord de mesurer l'indice optique de réfraction (n) de chacun des matériaux constituant les différentes couches (ou sous-couches) à déposer au cours de la fabrication de la structure, et ce pour une gamme de longueurs d'onde relativement limitée correspondant à la bande spectrale choisie. Ensuite, on contrôlera, ou on mesurera, l'épaisseur physique des couches déposées, compte tenu de la vitesse de dépôt des machines utilisées et des dimensions des structures à réaliser. Puis, on calculera le trajet optique moyen à partir de la formule $Tm = \int_c n_i \cdot ds$, et on en déduira les emplacements possibles d'intégration des sous-couches là où le carré du champ électrique optique des ondes stationnaires au sein de la structure est maximal, à partir de la relation $Tm = \lambda o(\frac{1}{4} + \frac{k}{2})$.

Même si sur la figure 1 il a été prévu d'intégrer à la sous-couche de conversion photoélectrique 7, trois sous-couches complémentaires, il doit être clair que cet exemple ne limite en rien le nombre des sous-couches en question. Aux figures 4, 6, 8 et 10, d'autres exemples de réalisation ont d'ailleurs été envisagés.

A la figure 4, on a illustré une variante de réalisation de la cellule solaire de la figure 1.

On notera que par souci de clarté, on a représenté les parties identiques avec les mêmes repères.

Sur la figure 4, on retrouve donc, en tant que constituant de la cellule solaire repérée 10, une couche transparente électriquement conductrice 5, une couche de conversion photoélectrique 7 et une électrode arrière repérée 19.

Sur cette cellule, qui est du type p-i-n, la sous-couche de type p, 7c vient au contact de la couche transparente 5, tandis que la couche de type n, 7a vient au contact de l'électrode arrière 19, laquelle est formée par un empilage comprenant une couche transparente électriquement conductrice 29 (de préférence fabriquée à base d'un oxyde métallique) venant au contact de la sous-couche de type n, 7a, et une couche électriquement conductrice 39 (notamment métallique) pourvue d'une surface réfléchissante 9a formée sur la couche tranparente conductrice 29. On remarquera également que la couche d'accrochage ou substrat 13 est ici disposée à l'arrière de la cellule, derrière la couche électriquement conductrice 39. Dans ce cas, le substrat pourra être opaque et être par exemple constitué à partir d'un métal, d'un matériau céramique ou d'un polymère.

Dans cette réalisation, on remarquera encore que dans la sous-couche i, 7b de la couche de conversion photoélectrique 7, n'a été incorporée qu'une seule sous-couche complémentaire 13a, laquelle a été disposée de telle sorte que le trajet optique moyen entre la surface réfléchissante 9a et le milieu de ladite sous-couche 13a soit égal à environ

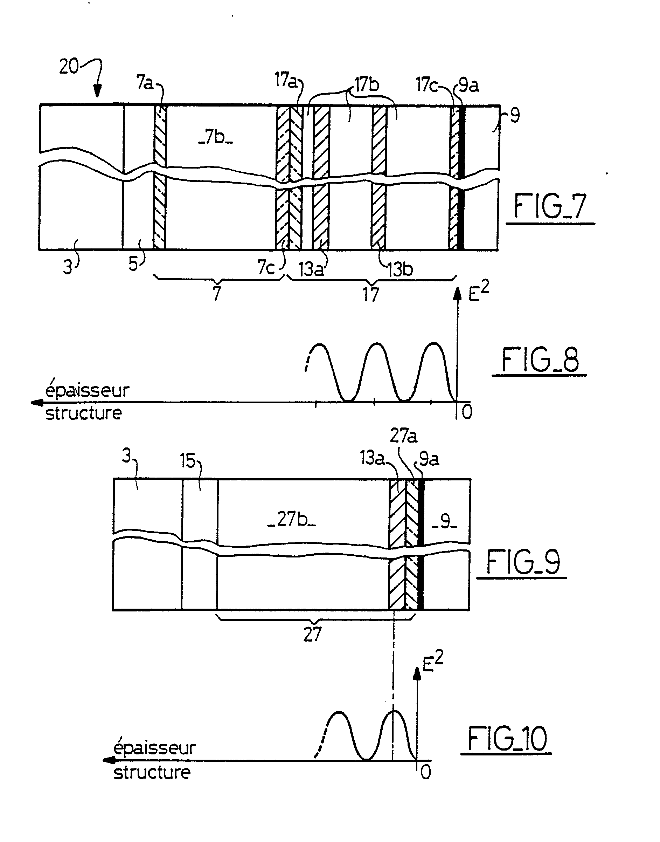

$$5 \frac{\lambda o}{4}$$ (voir figure 6).

En outre, l'épaisseur e de la couche transparente conductrice 29 a été optimisée pour que l'onde stationnaire de la figure 5 passe par un zéro en

$$\frac{\lambda o}{2}$$

au niveau de la sous-couche n, 7a. On notera que dans l'exemple illustré sur la figure 4, les couches 29 et 7b ont respectivement des indices optiques de réfraction (n) égaux à 2 et 4 environ, ce qui explique le décalage entre les figures 5 et 6. Bien entendu, une telle disposition aurait également pu être prévue sur d'autres types de structures photo-réceptrices telles que par exemple celle illustrée à la figure 1.

Intéressons-nous maintenant à la figure 7 pour voir représentée une cellule solaire différente 20 de type tandem n-i-p.

Les cellules tandem (ou multijonction) tant n-i-p que p-i-n sont bien connues. Celle illustrée figure 7 est constituée d'un empilage de couches minces comprenant successivement, en partant du côté qui reçoit la lumière incidente, un substrat transparent 3, une couche transparente électriquement conductrice 5, une première couche de conversion photoélectrique 7 comprenant, dans l'ordre, une sous-couche de type n, 7a, une sous-couche de type i, 7b et une sous-couche de type p, 7c. A cette première couche de conversion photoélectrique 7 est adjointe une seconde couche également de conversion photoélectrique 17 comprenant une sous-couche n, 17a, formée sur la sous-couche p, 7c, une sous-couche i, 17b, et une sous-couche p, 17c, sur laquelle est formée la surface réfléchissante 9a d'une électrode arrière 9. Bien entendu, d'autres types d'électrodes à surface réfléchissante auraient pu être utilisés, tels par exemple qu'un substrat en acier inoxydable à surface polie formant miroir. Dans ce cas, la prévision du substrat transparent 3 ne serait plus nécessaire.

Egalement, plus de deux couches de conversion photoélectrique auraient pu être prévues.

Conformément à l'invention, dans la sous-couche i, 17b, la plus proche de la surface réfléchissante 9a ont été en l'espèce intégrées deux sous-couches complémentaires 13a, 13b disposées à proximité immédiate des premiers maxima du carré du champ électrique optique des ondes stationnaires (voir figure 8), de telle sorte que le trajet optique moyen entre le milieu desdites sous-couches complémentaires et la surface réfléchissante 9a soit respectivement égal à

$$3 \frac{\lambda o}{4}$$ (sous-couche 13b) et

$$5 \frac{\lambda o}{4}$$ (sous-couche 13a).

Sur la figure 9, on a représenté un autre type de structure multicouche photo-réceptive s'apparentant à un détecteur capable par exemple de détecter des ondes lumineuses cohérentes issues d'un laser de type solide.

Plus précisément, la structure de la figure 9 comprend une succession de couches minces constituées, en partant de la zone par laquelle la structure est exposée à la lumière, d'un substrat transparent 3, d'une couche transparente électriquement conductrice 15 formant barrière de SCHOTTKY, d'une couche de conversion photoélectrique 27 comprenant une sous-couche de type i, 27b, formée sur la couche 15 et d'une sous-couche de type n, 27a sur l'arrière de laquelle est formée la surface réfléchissante 9a d'une électrode 9 métallique.

Pour former une barrière de SCHOTTKY, la couche 15 sera suffisamment fine pour se laisser traverser par la lumière, tout en étant suffisamment épaisse pour assurer une conductivité électrique planaire (c'est-à-dire dans une direction sensiblement perpendiculaire à son épaisseur). Une couche constituée à partir de platine, de palladium ou par exemple d'iridium et ayant une épaisseur comprise entre 5 et 10 nm environ serait tout à fait adaptée.

On notera encore que dans le cas illustré, seule une couche complémentaire 13a a été intégrée à la sous-couche intrinsèque 27b. Il se trouve que, compte tenu en particulier de l'épaisseur de la sous-couche de type n, 27a, la sous-couche complémentaire 13a est située en surface de la sous-couche 27b, directement au contact de la sous-couche n, 27a, le trajet optique moyen entre le milieu de cette sous-couche 13a et la surface réfléchissante 9a respectant toujours la même formule

$$Tm = \frac{\lambda_o}{4} + \frac{k\lambda_o}{2},$$

avec en l'espèce k = 0 (voir figures 9 et 10)

Il est clair qu'il ne s'agit là que d'un exemple de réalisation parmi d'autres puisque l'un des intérêts d'illuminer une structure à l'aide d'une lumière cohérente (laser) est d'obtenir des ondes stationnaires combinées incidentes et réfléchies qui seront cohérentes sur une grande distance, permettant de ce fait d'accroître le nombre des sous-couches complémentaires au sein de la (les) sous-couche(s) intrinsèque(s) des structures.

On va maintenant présenter quelques exemples pratiques de réalisation.

## EXEMPLE 1

Il s'agit de fabriquer une monodiode de type p-i-n comportant un miroir arrière "simple" et deux sous-couches complémentaires.

Les matériaux semi-conducteurs employés sont du silicium amorphe (seuil d'absorption optique 1,96 eV soit environ 633 nm), et un alliage silicium-germanium de l'ordre de 60 % de Si et 40 % de Ge) pour les sous-couches complémentaires (seuil d'absorption 1,7 eV soit environ 730 nm).

La bande spectrale visée est située entre 633 et 730 nm, centrée à environ 685 nm.

L'indice optique de réfraction (n) du silicium amorphe et du silicium monocristallin dans cette zone de longueurs d'onde est de l'ordre de 4. On notera qu'il s'agit d'une zone où cet indice varie très rapidement. Il convient donc d'optimiser la structure avec soin à partir de mesures et de calculs optiques précis.

Toutefois on peut estimer, avec une assez bonne précision, la position des différentes sous-couches complémentaires :
- sous-couche (13b) la plus proche du miroir (surface réfléchissante 9a) : $Tm = \lambda_o (\frac{1}{4} + \frac{k}{2})$, soit avec
$K = 0 : Tm = \frac{685}{4}$ ,
soit en terme d'épaisseur "physique" (avec un indice optique de 4 : d ≈ 43nm
- seconde sous-couche (13a), k = 1,

$$Tm = \frac{3 \times 685}{4}$$

soit d ≈ 129nm

Les distances respectives entre le milieu des sous-couches complémentaires et la surface réfléchissante 9a du miroir sont donc de l'ordre de 43 et 129 nm.

Le substrat (3) utilisé est du verre sodocalcique de 1 à 4 nm d'épaisseur.

La couche transparente conductrice (5) est constituée à base de $SnO_2$ dopé au fluor et ayant une épaisseur d'environ 45 nm. Cette couche présente, au contact de la sous-couche p (7a), une surface rugueuse.

La sous-couche de conversion photoélectrique (7) est réalisée comme suit :
- sous-couche p dopée au bore, d'épaisseur 15 nm environ
- sous-couche i (silicium amorphe intrinsèque) d'épaisseur 85 nm environ ,
- au sein de la sous-couche i, les deux sous-couches complémentaires (13b, 13a) à base de aSi:H-Ge ont chacune une épaisseur de l'ordre de 30 nm
- sous-couche n dopée au phosphore, d'épaisseur 30 nm environ.

Pour fabriquer une telle structure, il convient de bien connaître les propriétés optiques des matériaux utilisés et la vitesse de dépôt de la machine.

Pour fabriquer une telle structure, il convient de bien connaître les propriétés optiques des matériaux utilisés et la vitesse de dépôt de la machine.

Il faut en premier lieu calibrer par réflectométrie le temps nécessaire pour déposer, pour un matériau donné, une épaisseur optique déterminée (épaisseur correspondant à l'épaisseur "physique" mais tenant compte de l'indice optique des matériaux employés).

Ce calibrage effectué, le processus de fabrication s'établit comme suit :
- sur le substrat de verre est formée la couche (5) transparente conductrice. Son dépôt s'effectue par pulvérisation cathodique à magnétron (température de l'ordre de 50 à 100°C),
- sur la couche de $SnO_2$ est ensuite formée la couche de conversion photoélectrique (7) en utilisant la couche de conversion photoélectrique en utilisant une technique de type CVD à plasma et électrodes parallèles.

Pour la formation de la sous-couche p (repérée 7a à la figure 1), un mélange gazeux à base de $SiH_4$, de $B_2H_6$ et $CH_4$ est, de façon tout à fait classique, introduit dans la chambre à vide de l'appareil CVD à plasma et un dépôt "sous-vide" est réalisé avec une pression gazeuse de l'ordre de 4 Pa sous une puissance électrique radio-fréquence (fréquence 13,56 MHz et densité de puissance de 10 $mW/cm^2$). La puissance électrique est appliquée entre les électrodes parallèles de l'appareil (avant introduction des gaz, la dépression régnant dans l'enceinte de dépôt était de l'ordre de $10^{-4}$ Pa).

On dépose ainsi une sous-couche p d'épaisseur 5nm qui est dopée au bore et contient du carbone.

Le mélange gazeux de la chambre sous vide est alors remplacé par du silane ($SiH_4$) et la première partie de la sous-couche i (repérée 7b à la figure 1) est formée sur une épaisseur de 85 nm et sous une pression de 4 Pa.

La première sous-couche complémentaire (13a) est alors déposée sous atmosphère de $SiH_4$, $GeH_4$ et $H_2$ et sur une épaisseur de 30 nm. Au début de la formation de cette couche une mesure de réflectométrie est déclenchée, centrée à 685 nm.

La deuxième partie de la sous-couche i est ensuite formée sur une épaisseur de 60 nm (le dépôt est poursuivi jusqu'à ce que les mesures de réflectométrie indiquent que l'intensité de lumière réfléchie fournie par la source de lumière monochromatique a parcouru une frange).

Puis, la seconde sous-couche complémentaire (13b) est réalisée sur une épaisseur de 30 nm.

Après quoi, le gaz silane est remplacé par un mélange gazeux à base de silane et de $PH_3$ et la sous-couche n (repérée 7c à la figure 1) est formée sur une épaisseur de 30 nm et sous une pression de 4 Pa environ (arrêt du dépôt lorsque le réflectomètre indique un décalage d'une demi-frange supplémentaire).

Pendant la formation de la couche de conversion photoélectrique, la température du substrat de verre a été maintenue aux environs de 200°C.

Pour terminer, l'électrode arrière à surface réfléchissante est formée sur la couche de conversion photoélectrique par dépôt sous vide d'un film d'aluminium de 200 nm d'épaisseur.

## EXEMPLE 2

Les matériaux utilisés sont les mêmes que dans l'exemple 1.

La structure qui est encore du type p-i-n ne comporte qu'une seule sous-couche complémentaire.

Entre la surface réfléchissante (9a) du miroir arrière et la couche de conversion photoélectrique est interposée une couche transparente conductrice constituée à base de $SnO_2$:F ayant un indice optique de l'ordre de 2 et une épaisseur d'environ 117 nm.

On cherche toujours à améliorer la réponse spectrale aux alentours de 685 nm.

La position de la sous-couche complémentaire se calcule à partir du trajet optique par :
Tm = (demi-épaisseur de la sous-couche complémentaire (1)) x (indice optique du aSi:H, Ge) + (épaisseur de la partie (2) de la sous-couche i en aSi:H située entre la sous-couche complémentaire et la sous-couche n (3)) x (indice optique du aSi:H) + (épaisseur de la couche de $SnO_2$:F (4)) x (indice optique du $SnO_2$:F) ≈

$$\approx \frac{3 \times 685}{2}$$

(avec k = 1) soit Tm ≈ 514 nm.

On prendra donc comme épaisseur :
- pour la sous-couche (1) : 40 nm (épaisseur totale ; 2 x 20 nm)
- pour la sous-couche (2) : 20 nm
- pour la sous-couche (3) : 30 nm
- pour la sous-couche (4) : 117 nm

Avec de telles épaisseurs, on obtient en effet :
Tm = (20 x 4) + (20 x 4) + (30 x 4) + (117 x 2) = 514 nm

On notera que pour être parfaitement rigoureux, ce calcul devrait tenir compte de la réflexion partielle du rayonnement lumineux à l'endroit de l'interface $n/SnO_2$:F, laquelle renvoye environ 10 % de l'énergie.

## EXEMPLE 3

Mêmes matériaux que dans l'exemple 1.

La structure réalisée est du type cellule tandem $SnO_2$/p-i-n(aSi:H)/p-i-n (aSi:H), avec deux sous-couches de aSi:H-Ge/Ag.

Les épaisseurs des différentes couches et sous-couches sont dans l'ordre, les suivantes :
- $SnO_2$ : 45 à 50 nm
- p : 15 nm
- i (aSi:H) : 90 nm
- n : 20 nm
- p : 15 nm
- i (aSi:H) : 50 nm
- i (aSi:H-Ge) : 50 nm
- i (aSi:H) : 55 nm
- i (aSi:H-Ge) : 10 nm
- n : 30 nm
- électrode arrière à surface réfléchissante : 150 nm

## Revendications

1. Procédé pour améliorer, dans une bande déterminée de longueurs d'onde, la réponse spectrale d'une structure photoconductrice prévue pour recevoir un rayonnement lumineux et comprenant en succession :
- une couche transparente électriquement conductrice (5, 15),
- une couche de conversion photoélectrique (7, 17, 27, 27') constituée à partir d'un matériau semi-conducteur,
- et une électrode arrière (9, 19, 29) à surface réfléchissante (9a) permettant de réfléchir vers les couches précédentes un rayonnement incident après que celui-ci ait traversé lesdites couches, pour obtenir des ondes combinées stationnaires,
ledit procédé consistant à incorporer dans, ou à la surface de, la couche de conversion photoélectrique (7, 17, 27), au moins une sous-couche complémentaire (13a, 13b, 13c) de plus faible épaisseur constituée à partir d'un autre matériau semi-conducteur ayant un seuil d'absorption optique et une longueur de diffusion des charges électriques créées par le passage du rayonnement lumineux à travers la structure, inférieurs à celui, respectivement celle, du matériau constituant la couche de conversion photoélectrique,
caractérisé en ce qu'on incopore la (les) sous-couche(s) complémentaire(s) (13a, 13b, 13c...) dans le voisinage immédiat de l'une, ou de certaines, des zones (A, B, C) où le carré du champ électrique optique ($E^2$) des ondes stationnaires issues de la combinaison des rayonnements lumineux incident et réfléchi est maximal.

2. Procédé selon la revendication 1 caractérisé en ce que l'on dispose la sous-couche complémentaire qui est la plus proche de la surface réfléchissante (9a) de l'électrode de telle sorte que le trajet optique moyen (Tm) entre ladite surface réfléchissante et ladite sous-couche soit égal à environ $\lambda$ o$(\frac{1}{4} + \frac{k}{2})$, le trajet optique moyen séparant entre-elles les sous-couches complémentaires (dans le cas où plusieurs de ces sous-couches sont prévues) étant égal à environ $\dfrac{\lambda \ o}{2}$,

k étant un entier relatif positif ou nul et $\lambda$ o étant la longueur d'onde moyenne du rayonnement lumineux dans le vide et dans la bande de longueurs d'onde considérée, ladite bande étant située entre les seuils d'absorption optique des matériaux semi-conducteurs constituant la couche de conversion photoélectrique et la (les) sous-couche(s) complémentaire(s), respectivement.

3. Structure photo-réceptive multicouche comprenant un empilage de couches minces constitué par :
- une couche transparente électriquement conductrice formant une barrière SCHOTTKY (15),
- une couche de conversion photoélectrique (27, 27') formée sur une face de ladite couche transparente (15) et constituée à partir d'un matériau semi-conducteur, ladite couche de conversion photoélectrique comprenant une sous-couche de type (i) et une sous-couche de type (n),
- au moins une sous-couche complémentaire (13a, 13b, 13c) formée dans, ou sur, la sous-couche de type (i) (27b), ladite sous-couche complémentaire étant constituée à partir d'un autre matériau semi-conducteur ayant un seuil d'absorption optique et une longueur de diffusion des charges électriques créées par le passage du rayonnement lumineux à travers la structure, inférieurs à celui, respectivement celle, du matériau constituant ladite couche de conversion photoélectrique,
- une électrode arrière (9, 19) à surface réfléchissante (9a) formée sur une face de la couche de conversion photoélectrique et permettant de réfléchir vers les couches précédentes un rayonnement incident après que celui-ci ait traversé lesdites couches, pour obtenir des ondes combinées stationnaires,
- et un substrat (3, 13) formé soit sur une face de la couche transparente (15) opposée à celle où est formée la couche de conversion photoélectrique (dans ce cas le substrat est transparent), soit sur une face de l'électrode arrière opposée à celle où ladite électrode est formée sur cette même couche de conversion photoélectrique,

caractérisée en ce que la (les) sous-couche(s) complémentaire(s) est (sont) disposée(s) dans le voisinage immédiat de l'une, ou de certaines des, zone(s) où le carré du champ électrique optique des ondes stationnaires issues de la combinaison des rayonnements lumineux incident et réfléchi est maximal.

4. Structure photo-réceptrice selon la revendication 3 caractérisée en ce que la (les) sous-couche(s) complémentaire(s) est (sont) de type (i), intrinsèque.

5. Cellule solaire prévue pour recevoir un rayonnement lumineux et constituée par un empilement de couches minces comprenant :
- une couche transparente électriquement conductrice (5),
- une couche de conversion photoélectrique (7, 17) formée sur une face de la couche transparente (5) et constituée à partir d'un matériau semi-conducteur, ladite couche de conversion photoélectrique comprenant une sous-couche de type (i) interposée entre une sous-couche de type (p) et une sous-couche de type (n),
- au moins une sous-couche complémentaire formée dans, ou sur, la sous-couche de type (i), ladite sous-couche complémentaire étant constituée à partir d'un matériau semi-conducteur ayant un seuil d'absorption optique et une longueur de diffusion des charges électriques créées par le passage du rayonnement lumineux à travers la cellule inférieurs à celui, respectivement celle, du matériau constituant la couche de conversion photoélectrique,
- une électrode arrière (9, 19) à surface réfléchissante (9a) formée sur une face de la couche de conversion photoélectrique, et permettant de réfléchir vers les couches précédentes un rayonnement incident après que celui-ci ait traversé lesdites couches, pour obtenir des ondes combinées stationnaires,
- et un substrat (3, 13) formé soit sur une face de la couche transparente (5) opposée à celle où est formée la couche de conversion photoélectrique (dans ce cas le substrat est transparent), soit sur une face de l'électrode arrière (19) opposée à celle où ladite électrode est formée sur la couche de conversion photoélectrique,
caractérisée en ce que la (les) sous-couche(s) complémentaire(s) est (sont) disposée(s) dans le voisinage immédiat, de l'une ou de certaines, des zones où le carré du champ électrique optique ($E^2$) des ondes stationnaires issues de la combinaison des rayonnements lumineux incident et réfléchi est maximal.

6. Cellule solaire selon la revendication 5 caractérisée en ce que la (les) sous-couche(s) complémentaire(s) est (sont) de type (i), intrinsèque.

7. Cellule selon la revendication 5 ou la revendication 6 caractérisée en ce que la couche de conversion photoélectrique et la (les) sous-couche(s) complémentaire(s) comprennent respectivement du silicium et un alliage de silicium et de germanium.

8. Cellule selon la revendication 7 caractérisée en ce que dans le cas où l'on désire améliorer la réponse spectrale dans une gamme de longueurs d'onde comprise entre 630 et 760 nm, ladite cellule comprend entre une et trois sous-couches complémentaires (13a, 13b, 13c) qui sont disposées dans, ou sur, ladite sous-couche de type (i), de telle sorte que :
- l'épaisseur de la (chaque) sous-couche complémentaire est comprise entre 10 et 50 nm environ,
- le trajet optique moyen (Tm) qui sépare de la surface réfléchissante (9a) de l'électrode le milieu de la sous-couche complémentaire la plus proche de cette même surface réfléchissante est égal à environ 170 à 190 nm,
- et, dans le cas où la cellule comprend deux ou trois sous-couches complémentaires, la distance entre les milieux respectifs desdites sous-couches est de l'ordre de 80 à 100 nm.

9. Cellule solaire de type tandem prévue pour recevoir un rayonnement lumineux et comprenant un empilage de couches minces constitué par :
- une couche transparente électriquement conductrice (5),
- une électrode arrière (9) à surface réfléchissante (9a) formée sur ladite couche transparente (5) et permettant de réfléchir vers les couches précédentes un rayonnement incident après que celui-ci ait traversé lesdites couches, pour obtenir des ondes combinées stationnaires,
- au moins deux couches de conversion photoélectrique (7, 17) constituées à partir d'un matériau semi-conducteur et comprenant chacune une sous-couche de type (i) interposée entre une sous-couche de type (n) et une sous-couche de type (p), lesdites couches de conversion photoélectrique (7, 17) étant formées l'une sur l'autre, entre ladite couche transparente (5) et l'électrode arrière (9),
- au moins une sous-couche complémentaire (13a, 13b) formée dans, ou sur, la sous-couche de type (i) de l'une au moins des couches de conversion photoélectrique, ladite sous-couche complémentaire étant constituée à partir d'un matériau semi-conducteur ayant un seuil d'absorption optique et une longueur de diffusion des charges électriques créées par le passage du rayonnement lumineux à travers la cellule inférieurs à celui, respectivement celle, du matériau constituant les couches de conversion photoélectrique.
- et un substrat (3) formé soit sur une face de la couche transparente (5) opposée à celle où est formée l'une des couches de conversion photoélectrique (7) (dans ce cas le substrat est transparent), soit sur une face de l'électrode arrière (9) opposée à celle où cette même électrode est formée sur l'(une des) autre(s) couche(s) de conversion photoélectrique (17),

caractérisée en ce que la (les) sous-couche(s) complémentaire(s) (13a, 13b) est (sont) disposée(s) dans le voisinage immédiat de l'une, ou de certaines des, zones où le carré du champ électrique optique ($E^2$) des ondes stationnaires issues de la combinaison des rayonnements lumineux incident et réfléchi est maximal.

10. Cellule solaire selon la revendication 9 caractérisée en ce que la (les) sous-couche(s) complémentaire(s) est (sont) de type (i), intrinsèque.

FIG_1

FIG_2

FIG_3

FIG_4

FIG_5

FIG_6

FIG_7

FIG_8

FIG_9

FIG_10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4471155 (MOHR ET AL.) <br> * colonne 9, ligne 1 - colonne 10, ligne 15; figure 5 * <br> --- | 1, 5, 6, 7, 9, 10 | H01L31/075 <br> H01L31/052 |
| A | PATENT ABSTRACTS OF JAPAN <br> vol. 7, no. 84 (E-169)(1229) 08 avril 1983, <br> & JP-A-58 10871 (KOGYO GIJUTSUIN) 21 janvier 1983, <br> * le document en entier * <br> --- | 1, 5, 6, 7, 9, 10 | |
| A | US-A-4514583 (M.IZU ET AL.) <br> * colonne 8, ligne 5 - colonne 9, ligne 2; figure 1 * <br> --- | 1, 5, 6, 9, 10 | |
| A | US-A-4167015 (J.J.HANAK) <br> * colonne 3, lignes 7 - 66; figures 1, 2 * <br> --- | 3, 5 | |
| A | US-A-4376228 (J.C.C. FAN ET AL.) <br> * colonne 5, ligne 38 - colonne 6, ligne 2; figures 6, 7 * <br> ----- | 3, 5 | |

| DOMAINES TECHNIQUES RECHERCHES (Int. Cl.5) |
|---|
| H01L |

Le présent rapport a été établi pour toutes les revendications

| Lieu de la recherche | Date d'achèvement de la recherche | Examinateur |
|---|---|---|
| LA HAYE | 05 JUIN 1990 | LINA F. |

EPO FORM 1503 03.82 (P0402)